# EUROPEAN PATENT APPLICATION

(11) **EP 4 644 993 A1**
(43) Date of publication of application: **05.11.2025**
(21) Application number: 24173057.1
(22) Date of filing: 29.04.2024
(51) Int. Cl.: G03F 7/20

(54) **QUALITY MONITORING IN MICROLITHOHRAPHY DEVICES**

(71) Applicant: Mycronic AB, 183 03 Täby (SE)
(72) Inventor: WALTHER, Jonas, 169 37 Solna (SE)
(74) Representative: AWA Sweden AB

(57) **Abstract**

A method for quality monitoring in microlithography devices comprises interacting (S10) with a two-dimensional pattern on a target by exposing the target for electromagnetic radiation. The exposing is performed using optical components defining an optical path. Acoustic signals are recorded (S11) in vicinity of the optical path during the interaction. The recorded acoustic signals are associated (S20) to positions of the two-dimensional pattern where the interaction with the pattern was performed when respective acoustic signals were recorded. A quality of the interaction with the two-dimensional pattern is monitored (S30) based on the associated acoustic signals and pattern positions. A microlithography device monitorable by the method is also disclosed.

## Description

### TECHNICAL FIELD

The present technology refers in general to generation of patterns and in particular to methods and arrangements for quality monitoring in pattern generators.

### BACKGROUND

Today, pattern generators of different kinds providing high-precision patterns are used for many purposes. Photolithography is commonly used to generate a pattern on a surface. The generated features may have very small sizes, even down to sub-micrometer ranges. Acousto-optical light modulation is often used in these technologies. In a laser writer, a laser is used as the light source to activate the photoresist by means of optical arrangements. A mask writer may be used to write photomasks.

In most types of precision pattern generators, a two-dimensional pattern is provided on a target by exposing the target for radiation, typically electromagnetic radiation. The exposing is typically performed using optical components. The optical components define an optical path, directing the radiation to selected parts of the target. The radiation can be scanned or swept by optical means and/or by moving the arrangement of optical components relative the target. The radiation is typically provided according to predefined pattern print data, defining the pattern to be printed.

Other types of microlithography devices, such as e.g. pattern inspection devices or pattern measuring devices, operates with similar types of optical systems.

High precision pattern generators as well as inspection or meteorology devices are sensitive to disturbing frequencies, especially disturbances generating systematic deviations to the exposed target. As the generated patterns are in sub micrometer scale, even the slightest vibration may transfer to the pattern. The high precision part of the pattern generator or meteorology tool is therefore normally isolated from external vibrations with a low resonance frequency interface. Any remaining mechanically induced vibration disturbances are traditionally detected with sensors measuring mechanical movement.

However, despite extreme care to avoid vibrations, printed patterns sometimes present different kinds of erroneous structures, e.g. different kinds of mura. Such effects may sometimes be associated with disturbances sensed by e.g. position sensors or accelerometers. However, in some cases, mura may be present although the position sensors or accelerometers do not reveal any probable causes therefore.

In order to assure good quality patterns, it therefore exists a need for a more accurate monitoring of induced errors, if any.

### SUMMARY

A general object of the present technology is to enable an improved quality monitoring in pattern generators.

The above object is achieved by methods and devices according to the independent claims. Preferred embodiments are defined in dependent claims.

In general words, in a first aspect, a method for quality monitoring in microlithography devices comprises interacting with a two-dimensional pattern on a target by exposing the target for electromagnetic radiation. The exposing is performed using optical components defining an optical path. Acoustic signals are recorded in vicinity of the optical path during the interaction. The recorded acoustic signals are associated to positions of the two-dimensional pattern where the interaction with the pattern was performed when respective acoustic signals were recorded. A quality of the interaction with the two-dimensional pattern is monitored based on the associated acoustic signals and pattern positions.

In a second aspect, a microlithography device comprises optical components, interaction control means, at least one acoustic sensor and a quality monitor. The optical components define an optical path. The printing control means is configured for controlling a relative movement of the optical path in two dimensions relative to a target. Thereby exposure of a two-dimensional pattern for electromagnetic radiation is enabled. The at least one acoustic sensor is arranged in vicinity of the optical path. The quality monitor is communicationally connected to or integrated with the interaction control means and communicationally connected to the at least one acoustic sensor. The quality monitor is configured for recording the acoustic signals during interaction operations and for associating the recorded acoustic signals to positions of the two-dimensional pattern where interaction with the pattern was performed when respective the acoustic signals were recorded. The quality monitor is further configured for monitoring a quality of the interaction with the two-dimensional pattern based on the associated acoustic signals and pattern positions.

One advantage with the proposed technology is that it enables detection of acoustic disturbances that bypass any mechanical vibration isolation and affect sensitive components or laser light, thereby allowing association of acoustic anomalies and positions at the printed pattern. Other advantages will be appreciated when reading the detailed description.

### BRIEF DESCRIPTION OF THE DRAWINGS

The invention, together with further objects and advantages thereof, may best be understood by making reference to the following description taken together with the accompanying drawings, in which:
FIG. 1 schematically illustrates a typical scanning lithographic laser writer;
FIGS. 2A and 2B are diagrams illustrating a standard deviation of recorded sound for a number of strips;
FIG. 3 correlates the appearance of printing deviations and increased acoustic sound;
FIG. 4 is a flow diagram of steps of an embodiment of a method for quality monitoring in microlithography devices;
FIG. 5 is a schematic drawing of an embodiment of a microlithography device;
FIG. 6 is a flow diagram of steps of an embodiment of a monitoring step of a quality of the interaction with the two-dimensional pattern;
FIG. 7 is a XY plot of sound amplitude showing intermittent acoustic disturbances and where they are located on a substrate; and
FIG. 8 is a map of intensities averaged over a scan in the X-direction as a function of frequency.

### DETAILED DESCRIPTION

Throughout the drawings, the same reference numbers are used for similar or corresponding elements.

For a better understanding of the proposed technology, it may be useful to begin with a brief overview of one example of a microlithography device, in this particular case a pattern generator, in which the present technology can be applied. It should, however, be noted that the application of the present technology is not limited to this particular example, but is generally applicable to any pattern generation device using optical components defining an optical path for performing the exposure, e.g. using a laser as the light source to activate the photoresist. Photolithography devices, laser writers, mask writers etc. are non-limiting examples in which the present technology may be applied.

It is also possible to apply the proposed technology to other types of microlithography devices, such as e.g. pattern measuring devices or pattern inspection devices.

The radiation used for the microlithography devices in the present technology is electromagnetic radiation, preferably in the infrared, visible or ultraviolet spectra. The optical elements are light optical elements capable of interaction with electromegnaetic radiation.

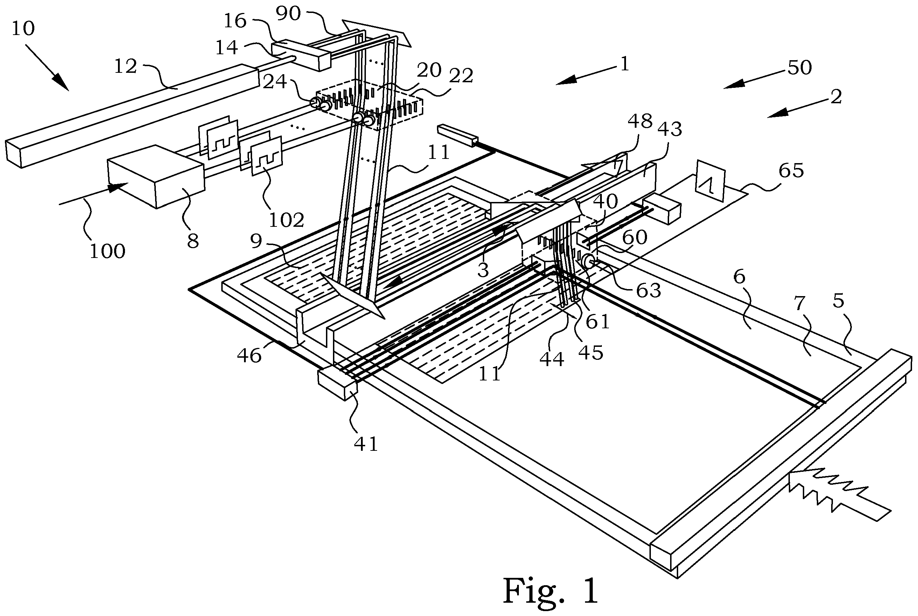

A model system of a scanning lithographic laser writer 1 is schematically illustrated by Figure 1. The scanning lithographic laser writer 1 is an example of a microlithography device 50. In an irradiation arrangement 2, a laser beam is generated by a laser source 12. A beam splitter 14 in the shape of a Diffractive Optical Element (DOE) 16 splits the laser beam into a number of separate beams 90. A set of mirrors and other optical elements direct the separate beams 90 along an optical path 11 to irradiate a light-sensitive target 7 of a substrate 6 at a substrate holder 5, to create a pattern 9 of exposures in the light-sensitive target 7. A movable writing head 40 comprises a final lens, similar to an objective, that focuses the light onto the substrate 6. The final lens determines the resolution of the system. Each lens, mirror, optical crystal, etc. has some error, giving an energy spread. Predefined pattern print data 100 is provided to a control unit 8 for a multichannel acousto-optical modulator 20.

In the acousto-optical modulator 20, transducers 24 are used for creating acoustic waves through an acousto-optical crystal 22. Depending on the interaction between the acoustic waves and the separate laser beams 90 within the acousto-optical crystal 22, the separate laser beams 90 can be switched on and off in registry with the moving of the separate laser beams 90 over the light-sensitive target 7, thereby giving rise to the requested pattern.

The control unit 8 provides modulated radio-frequency signals 102 based on the print data to respective transducers 24 of the multichannel acousto-optical modulator 20 via electrical input connectors.

The separate laser beams 90 are moved over the light-sensitive target by several mechanisms. A Y-interferometer 41 utilizes laser beams from a laser source to determine the position of the separate laser beams 90 in a Y direction. An X-interferometer is analogously determining the position in an X direction. Mirrors at the movable writing head 40 are used for this purpose. The writing head 40 in an X-carriage is movable along an X-bridge 43 in the direction of the light propagation path 3, as indicated by the arrow 48, and the substrate holder 5 is movable stepwise in the Y-direction relative to the X-bridge 43 as indicate by an arrow. The X-carriage thus scans in the X direction (scan strips). During the X-carriage return stroke, the Y-stage carrying the substrate holder 5 moves one step length (scan strip width). A microsweeping is also available in the Y direction by sweeping the separate laser beams 90 as indicated by the arrow 44, thereby moving the irradiation spots 45 of the separate laser beams 90. The microsweeping is in this embodiment achieved by an acousto-optic deflector 60, having an acousto-optical crystal 61. A transducer 63 is provided with a sweep signal 65, that is coordinated with the other motions and with the predefined patterns print data 100. The exposure is thus made by writing several microsweeps in one scan strip. The AOD deflector crystal 61 generates a sweep for all separate beams 90 together and controls power and linearity over the sweep.

The printed pattern 9 on the light-sensitive target 7 thus depends on that the separate laser beams 90 are given the right modulation in agreement with the microsweeping and other movement action of the printing head. The AOM modulator crystal 22 controls the power for each separate beam 90 and converts the predefined pattern print data 100 to exposure light.

The high precision part of the scanning lithographic laser writer 1 is normally isolated from external vibrations with a low resonance frequency interface. All active parts of the scanning lithographic laser writer 1 are typically mounted on the same base stone. The isolation acts as a low pass frequency filter reducing frequencies above the resonance frequency from being mechanically transferred to the sensitive parts. The large mass of fundamental parts also acts as a barrier for the mechanical transfer of higher vibration frequencies.

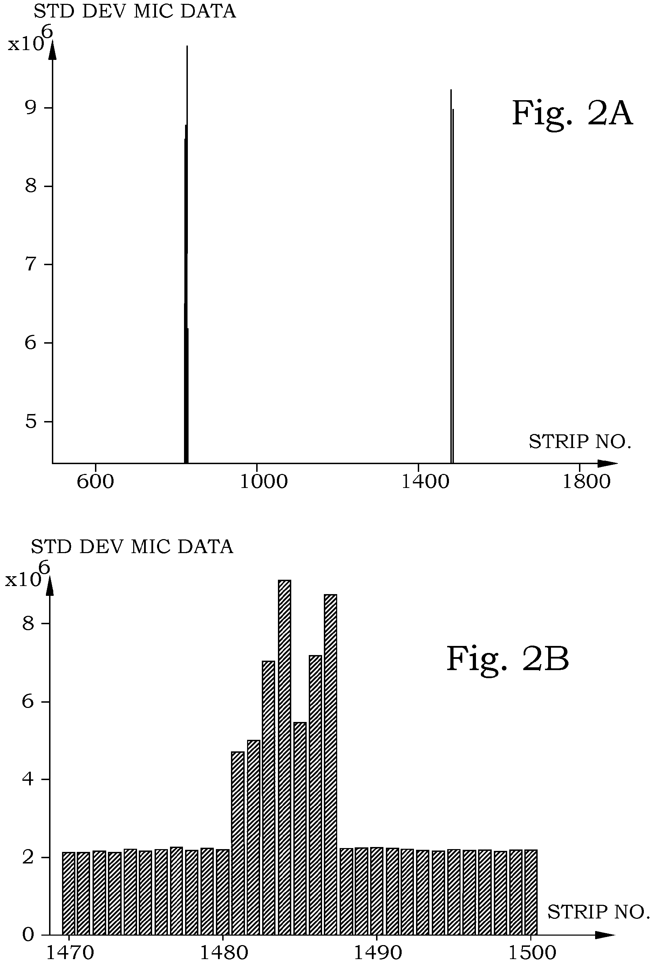

Figure 2A is a diagram illustrating a standard deviation of recorded sound for a number of strips. The diagram clearly points out strips that deviates considerably from the other. A closer look at one area is illustrated in Figure 2B and shows that there are just a few strips that deviates. At the same time, position sensors and accelerometers attached to the system did not reveal any unusual behaviour during the printing of these particular strips.

However, it is now realized that vibrations caused by acoustic energy source can be difficult to trace or isolated. The present technology is thus focused on any direct acoustic disturbances of the light path 11 between the laser source 12 and the light-sensitive target 7.

Acoustic disturbances may bypass the vibration isolation and hit resonance frequencies in e.g. optical components directly without being transferred by any mechanical components. In other words, the acoustic signals may trig a component oscillation directly. The optical components are typically very small and to provide mechanical vibration sensors directly onto the components is very difficult. The acoustic signals may also directly disturb the transmitted light without any mechanical contact since the refraction index of gases through which the light is travelling in the light path may differ with differing pressures. Vibrations in optical components affected by acoustic energy are thus difficult to measure on with mechanical sensors. Such disturbances may e.g. cause a disturbance in the position or shape of the writing beam. If interferometer beams are used for positioning, the wavelength of interferometer beams may also be disturbed.

One idea is thus to use an acoustic sensor to detect external disturbances and internal malfunction in high precision mask writers and meteorology tools. The acoustic sensor is mounted in a vicinity of the light path of the printing device.

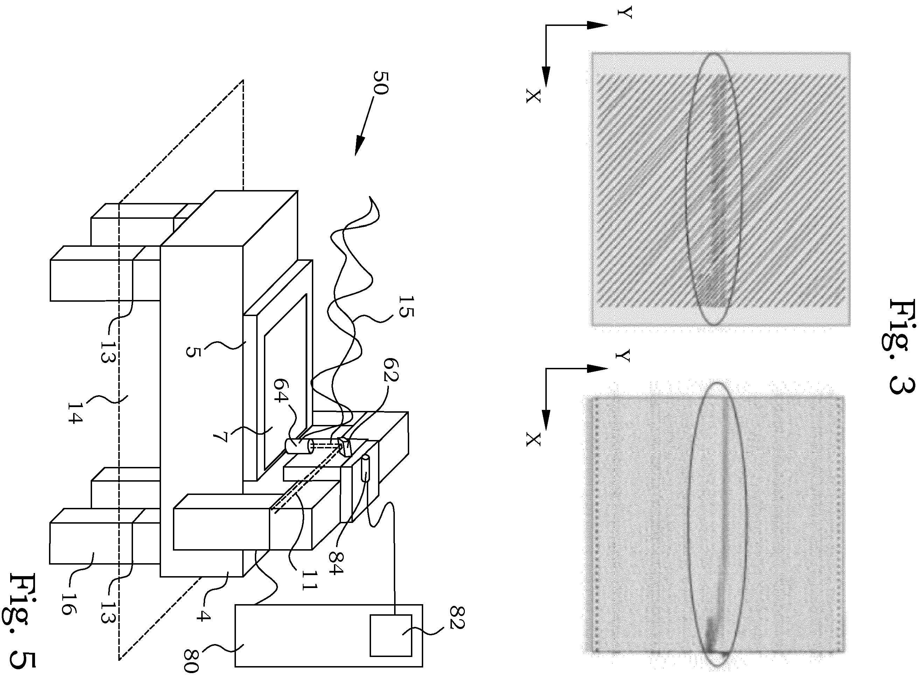

Figure 3 illustrates schematically, in the left diagram, deviations of a printing of an area of a printed target. In the right diagram, acoustic amplitudes, measured at the same time as the printing, are illustrated. In other words, the acoustic amplitudes are associated to positions of the printed two-dimensional pattern at the target, which positions of the pattern was generated when the respective acoustic signals were recorded. It is obvious that there is a correlation between the occurrence of a printing deviation and the existence of an acoustic signal. Such maps of amplitudes associated with positions of the created pattern may thus give information about if potentially detrimental acoustic signals were present during printing, and if so, where to look at the printed target in order to determine if the acoustic signals gave rise to any unacceptable printing deviations. In other words, acoustic disturbances can be mapped to mask position for assisting in e.g. mura correlation analysis.

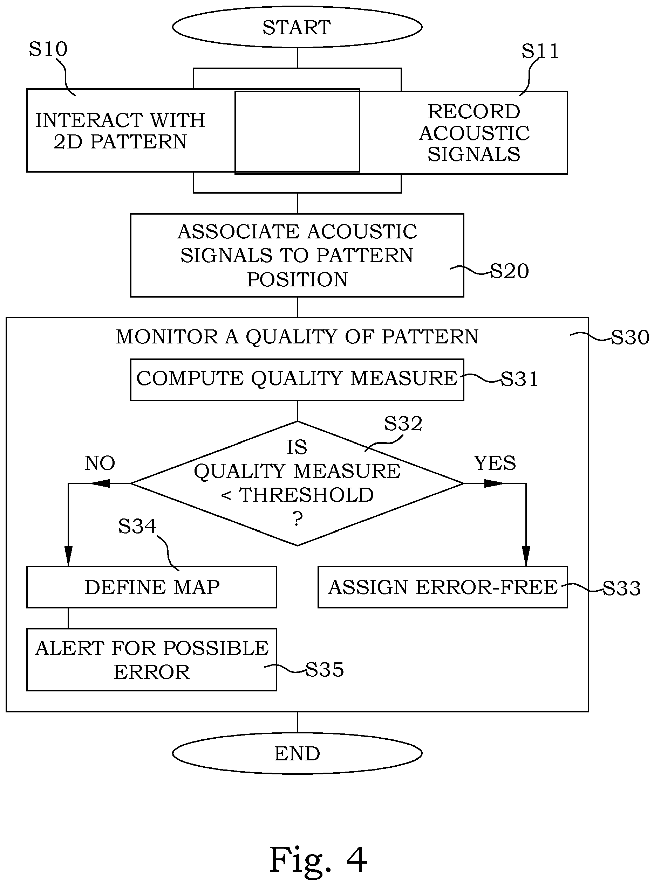

Figure 4 is a flow diagram of steps of an embodiment of a method for quality monitoring in microlithography devices. In step S 10, in interaction with a two-dimensional pattern on a target is performed by exposing the target for electromagnetic radiation. The interaction is performed using optical components defining an optical path.

In the case the microlithography device is a pattern generator, the step S10 comprises generation of a two-dimensional pattern on a target by exposing the target for electromagnetic radiation according to predefined pattern print data.

In the case the microlithography device is a pattern measuring device, the step S10 comprises generation of a two-dimensional image of a pattern on a target by exposing the target for electromagnetic radiation.

In the case the microlithography device is a pattern inspection device, the step S10 comprises generation of deviance data of a pattern on a target in relation to predefined pattern print data by exposing the target for electromagnetic radiation.

In step S 11, acoustic signals in vicinity of the optical path are recorded. This is performed during the step S10 of interacting. In other words, steps S10 and S 11 are performed at the same time, i.e. simultaneously. In step S20, the recorded acoustic signals are associated to positions of the two-dimensional pattern where interaction with the pattern was performed when respective acoustic signals were recorded. In other words, when the electromagnetic radiation interacts with a certain point at the target, acoustic signals that are recorded simultaneously are also associated with that point. In step S30, a quality of the interaction with the two-dimensional pattern is monitored based on the associated acoustic signals and pattern positions.

An acoustic sensor, e.g. a microphone, near vibration sensitive parts enables detection of disturbances that may generate systematic errors, so-called mura, on the exposed mask. The acoustic sensor measurements can, besides the position association, be logged together with other sensors. The measurements may thus be correlated to other sensor measurements as well as to the position on the mask in analysis. Thus, the relation between errors in the generated mask and detected noise may be determined.

By having an acoustic sensor measuring the acoustic signals directly in the space surrounding the printing/inspection/measuring equipment, acoustic disturbances that bypass the vibration isolation and that may affect sensitive components or laser light may be detected. Such disturbances may concern both exposure laser light and/or interferometer laser light. Measured acoustic signal and thereby potential acoustic disturbances can be mapped to mask position, and may eventually be used e.g. for mura correlation analysis.

In the particular embodiment of Figure 4, the step S30 of monitoring a quality in turn comprises the step S31, in which at least one quality measure is computed. The computation is based on amplitudes of the associated acoustic signals. In step S32, it is determined whether or not the quality measure exceeds a predetermined threshold. If the quality measure is below a predetermined threshold, the process continues to step S33, in which the pattern is assigning to be free from acoustically generated errors. If the quality measure exceeds the predetermined threshold, the process continues to step S34. In a preferred embodiment, in step S34, a map of areas of the target in which the quality measure exceeds the predetermined threshold is defined. In step S35, an operator is alerted with a warning for possible interaction errors. Preferably, the warning comprises the map defined in step S34.

Figure 5 illustrates schematically an embodiment of a microlithography device 50. The microlithography device 50 comprises optical components defining an optical path 11. Examples of such optical components may e.g. be mirrors 62, lens systems 64, acousto-optic deflectors, interferometers etc. The microlithography device 50 further comprises interaction control means 80. The interaction control means 80 is configured for controlling a relative movement of the optical path 11 in two dimensions relative to a target 7.By this, an exposure of a two-dimensional pattern for electromagnetic radiation is enabled. An interaction control means 80 is, as such, known in prior art, and in dependence of the type of microlithography device 50, it may have slightly different tasks.

The microlithography device 50 may be a pattern generator. One typical example is illustrated in Figure 1. The interaction control means 80 is then a printing control means configured for controlling a relative movement of the optical path 11 in two dimensions relative to the target 7. The printing control means is further configured for modulating electromagnetic radiation reaching the target 7 through the optical path 11 according to predefined pattern print data. Thereby, exposure of a two-dimensional pattern is enabled.

The microlithography device 50 may be a pattern measuring device. The interaction control means 80 is then a measuring control means configured for generating a two-dimensional image of a pattern on a target 7 by exposing the target 7 for electromagnetic radiation.

The microlithography device 50 may also be a pattern inspection device. The interaction control means 80 is then an inspection control means configured for generating deviance data of a pattern on a target 7 in relation to predefined pattern print data by exposing the target 7 for electromagnetic radiation.

The microlithography device 50 is supported on a base stone 4. The base stone 4 is in turn supported by legs 16 to the floor. The legs 16 comprises vibration isolators 13, which isolates the base stone 4 from mechanical vibrations originating from the floor. This leads to that the microlithography device 50, above a vibration isolation level 14, is isolated from mechanically transferred vibrations, in particular high-frequency mechanical vibrations.

However, it is now understood that acoustic waves 15 also may influence the optical components defining the optical path 11 or the light itself in the optical path 11. The vibration isolators 13 are thereby bypassed by acoustic disturbances.

In order to at least have control over possible errors in the operation of the microlithography device 50, the microlithography device 50 further comprises at least one acoustic sensor 84 arranged in vicinity of the optical path 11. The microlithography device 50 further comprises a quality monitor 82 communicationally connected to or integrated with the interaction control means 80 and communicationally connected to the at least one acoustic sensor 84. The quality monitor 82 is configured for recording the acoustic signals during interaction operations. The quality monitor 82 is also configured for associating the recorded acoustic signals to positions of the two-dimensional pattern where interaction with the pattern was performed when respective acoustic signals were recorded. In other words, when the electromagnetic radiation interacts with a certain point at the target, acoustic signals that are recorded simultaneously are associated with that point. The quality monitor 82 is further configured for monitoring a quality of the interaction with the two-dimensional pattern based on the associated acoustic signals and pattern positions.

Once the acoustic signals are recorded, any interesting content therein may be detected. The step S31 (Fig. 4) can in different applications be configured in many different ways. One approach is simply to monitor the total energy in the recorded acoustic signal. In this case, the frequency information is abandoned, and a measure of an "average" amplitude is achieved.

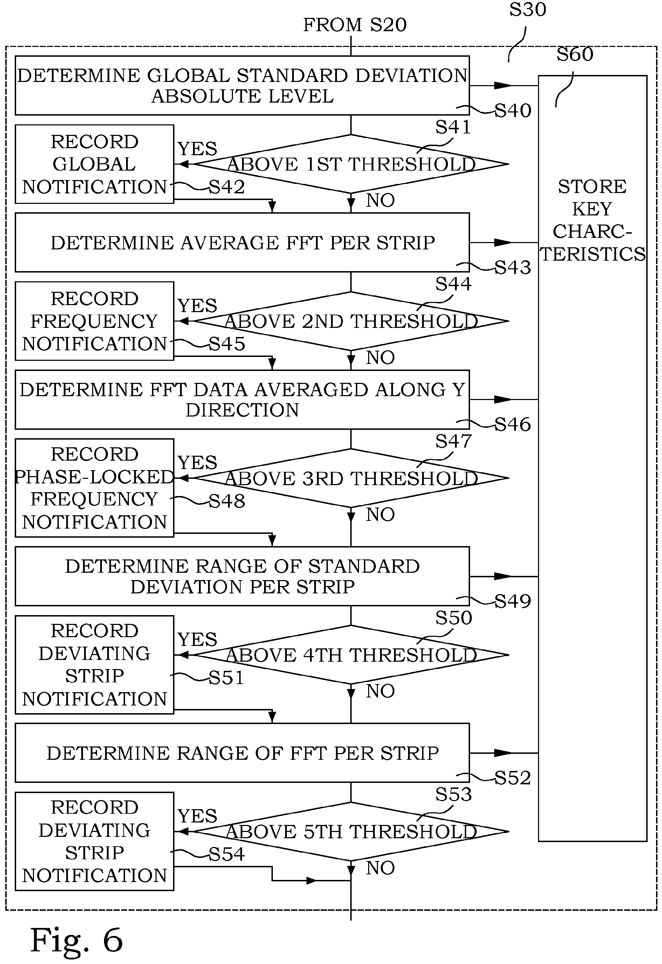

Figure 6 illustrates one embodiment of a monitoring step S30 of a quality of the interaction with the two-dimensional pattern. In this embodiment swept strips in Y direction and mechanical movement in the X direction are assumed to be used during the printing. In step S40, an absolute level of a global standard deviation of the acoustic signal is determined. The global standard deviation is a single figure of merit over the complete recorded sound data. A high global standard deviation is an indication of a general high noise level during the job. Such a quantity catches jobs with higher noise level than normal even if there is no specific troublesome frequencies or specific bad strips. The results are provided S60 to a key characteristics storage. In step S41, the global standard deviation absolute level from step S40 is compared to a predetermined first threshold. If the global standard deviation absolute level exceeds the predetermined first threshold, the process continues to step S42 in which a global notification is recorded, before the process continues by step S43. If the global standard deviation absolute level is below the predetermined first threshold, the process continues directly to step S43.

In step S43, a Fast Fourier Transform (FFT) is averaged over each strip. The FFT of the noise is thereby calculated for each strip and then the FFT is averaged for all strips along the frequency axis. This will cancel out frequencies that only occurs intermittent in one or a few strips. The remaining peaks are most likely present in a significant part of the job and occur with a very stable frequency. A stable frequency that is present in a significant part of the job, but not phase-locked to X position, could typically be emanating from an uncorrelated source, like a fan, a pump or some other external machinery. The results are provided S60 to the key characteristics storage. In step S44, the average FFT from step S43 is compared per frequency to a predetermined second threshold. If the average FFT exceeds the predetermined second threshold for any frequency, the process continues to step S45 in which a frequency notification is recorded, before the process continues by step S46. If the average FFT is below the predetermined second threshold for all frequencies, the process continues directly to step S46.

In step S46, an FFT is averaged along the Y direction. Sound data is averaged along the Y direction and then the FFT of the averaged data is calculated. The averaging will cancel out frequencies that are not in phase in each strip. Remaining peaks in the FFT are most likely phase-locked to the X position and strip execution. Such frequencies may possibly be generated by the movement or by some other strip specific event. Extracting only phase-locked frequencies allows for a very low threshold and should catch the disturbances that are most prune to generate mura. The results are provided S60 to the key characteristics storage. In step S47, the average FFT along the Y direction from step S46 is compared per frequency to a predetermined third threshold. If the average FFT along the Y direction exceeds the predetermined third threshold for any frequency, the process continues to step S48 in which a phase-locked frequency notification is recorded, before the process continues by step S49. If the average FFT along the Y direction is below the predetermined third threshold for all frequencies, the process continues directly to step S49.

In step S49, a range of standard deviation of the acoustic signals per strip is determined. Standard deviation as a single figure of merit over the recorded sound data is here measure for each strip. A high value is an indication of a general high noise level for a particular strip. This quantity catches specific strips that are worse than normal even if there are no specific deviating frequencies and the overall jobs level is satisfactory. Such signals could be caused by more random noise sources like for instance turbulent air flow, air leakage or scratching surfaces. The results are provided S60 to the key characteristics storage. In step S50, the range of standard deviation of the acoustic signals per strip from step S49 is compared to a predetermined fourth threshold. If the average range of standard deviation of the acoustic signals per strip exceeds the predetermined fourth threshold, the process continues to step S51 in which a deviating strip notification is recorded, before the process continues by step S52. If the range of standard deviation of the acoustic signals per strip is below the predetermined fourth threshold, the process continues directly to step S52.

In step S52, a range of FFT per strip is determined. A maximum peak amplitude of any frequency for each strip can thus be determined. A high value indicates a strong disturbance from a specific frequency for that particular strip. This measure catches an intermittent disturbing frequency that will be averaged out with the above presented averaging methods. The results are provided S60 to the key characteristics storage. In step S53, the range of FFT per strip from step S52 is compared to a predetermined fifth threshold. If the FFT per strip exceeds the predetermined fifth threshold, the process continues to step S54 in which a deviating strip notification is recorded. If the FFT per strip is below the predetermined fourth threshold, the process ends.

Depending on what disturbances that is of major interest in certain applications, any selection of the above presented data analyses can be used and the evaluation can thus adapted to different applications.

The key characteristics storage allows monitoring of trending per job as well as trending over time. This enables detection of anomalities and/or machine degradation, giving means to provide knowledge-based preventive maintenance.

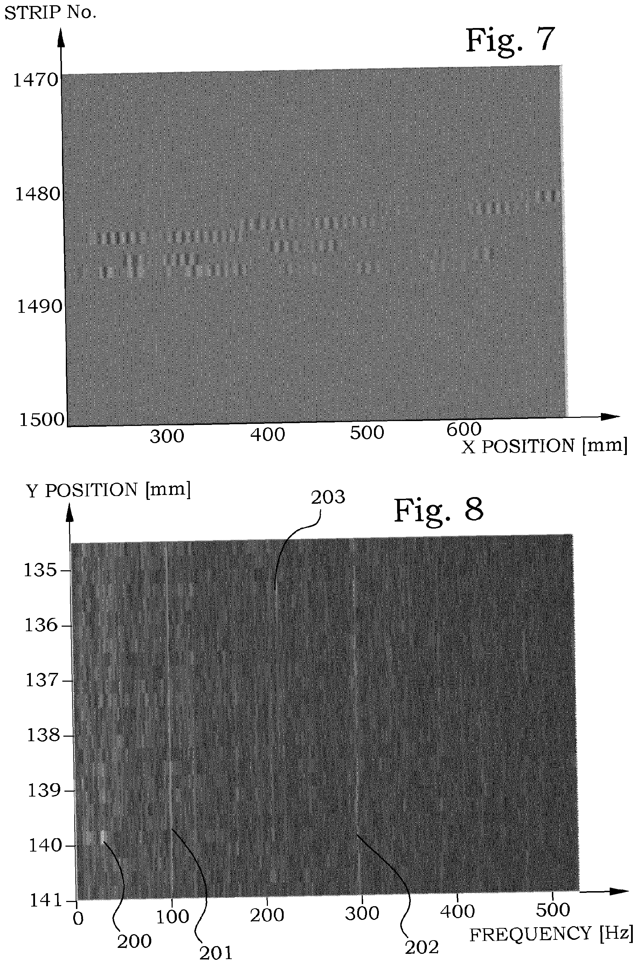

Figure 7 is a XY plot of the sound amplitude showing intermittent acoustic disturbances and where they are located on the substrate.

However, as discussed above, the frequency information is typically also of use, and in preferred embodiments, a frequency analysis is also made. In one approach the computing of at least one quality measure comprises calculating of a first average measure of amplitudes along a first direction in the two-dimensional pattern. This first direction can e.g. along the sweep direction or the scan direction of the microlithography device. This is useful for suppressing noise in the signals to reveal systematic behaviours.

Systematic appearances of high-amplitude acoustic signals may indicate an increased risk for causing mura errors. In other words, in one embodiment, the step of computing one or more quality measure comprises searching for systematic appearances, with respect to the associated positions at the two-dimensional pattern, of enhanced amplitudes in the recorded acoustic signals. The possible printing errors may comprise mura.

Alternatively, or as a complement, a first variation measure of the amplitudes, e.g. the standard deviation, can be calculated along a first direction in the two-dimensional pattern. The quality measure, used for determining if alerts should be issued or not, is then based on the first average measure and/or the first variation measure.

The same approach can of course also be performed in a second, perpendicular direction. In other words, in one embodiment, the step of computing at least one quality measure comprises calculating a second average measure and/or second variation measure of amplitudes along a second direction in the two-dimensional pattern. The second direction is transverse to the first direction. Thereby, the quality measure may be further based on the second average measure and/or the second variation measure.

In Figure 8, a "one-dimensional" map of intensities averaged over a scan in the X-direction as a function of frequency is illustrated. It is in other words, a spectrum plot of the sound amplitude for all strips showing the total frequency content in each strip. It may be distinguished at the reference number 201 that a frequency of 100 Hz is present with a higher amplitude than other frequencies throughout the entire pattern. This was later possible to deduce that a cleanroom fan caused this acoustic frequency signal. Moreover, close to the Y position 140 mm, at reference number 200, a broadband low frequency disturbance was detected in just one single strip. This therefore corresponds to a temporary sound of unknown origin, which may have caused errors in the printing at a Y position of 140 mm. Another frequency with higher intensity than expected occurs at about 300 Hz, c.f. ref. No. 202. The occurrence at all Y positions indicates that the origin is from an outside sound source or of an operation that occurs for every scan. Also at ref. number 203, a temporary acoustic disturbance was found at about 220 Hz. This intermittent disturbance only lasted for one single scan.

In this way, different kinds of alerts or analyses can be made, giving information about frequency spectra and time duration of different interfering acoustic signals. Such information can be used for alerting an operator if the deviations from normal or expected sound levels are larger than a predetermined threshold. This information also enables machine diagnostics and detection internal vibrations. Prominent frequencies appearing in the acoustic signals are associated with certain positions or ranges of the pattern. Since it also is known what operation sequences are active at different time periods of the pattern interaction, there is also a correlation between such prominent frequencies and different operation sequencies.

In other words, in one embodiment, the step of monitoring a quality comprises identifying of prominent frequencies in the recorded acoustic signals. Periods of appearance of the prominent frequencies can then be correlated to operation sequences of the pattern generation. Some operations may be active only during limited time periods, and if such time periods coincide with the time periods within which the acoustic signals are present, there may be a connection therebetween. In a preferred embodiment, the step of monitoring a quality further comprises deriving of possible acoustic sources from pattern generator parts being active only during the operation sequences. Machine diagnostics and detection of internal vibrations may thereby be performed.

An acoustic sensor could also be used to detect slow deterioration of components by trending the recorded sound over time during similar conditions. Having access to historical recordings of acoustic signals during similar outer conditions could reveal indications of that certain parts of the microlithography device may be exposed to e.g. wear. By logging recordings of similar processes from a number of occasions spread in time, a time-dependency may be detected. Parts that might have to be replaced can thus be detected very early, avoiding erroneous printings/inspections etc. due to wear of components.

In other words, in one embodiment, the monitoring comprises the further step of storing the recorded acoustic signals and their associated pattern positions from different printing sessions in a history database. In a preferred embodiment, the history database is searched for trends in acoustic signal changes with time. Possible needs of maintenance may be proposing based on these trends.

The embodiments described above are to be understood as a few illustrative examples of the present invention. It will be understood by those skilled in the art that various modifications, combinations and changes may be made to the embodiments without departing from the scope of the present invention. In particular, different part solutions in the different embodiments can be combined in other configurations, where technically possible. The scope of the present invention is, however, defined by the appended claims.

## Claims

1. A method for quality monitoring in microlithography devices (50), comprising:
- interacting (S10) with a two-dimensional pattern on a target (7) by exposing said target (7) for electromagnetic radiation;
wherein said exposing is performed using optical components (62, 64) defining an optical path (11);
- recording (S11) acoustic signals (15) in vicinity of said optical path (11) during said step of interacting (S10);
- associating (S20) said recorded acoustic signals (15) to positions of said two-dimensional pattern where interaction with said pattern was performed when respective said acoustic signals (15) were recorded; and
- monitoring (S30) a quality of said interaction with said two-dimensional pattern based on said associated acoustic signals (15) and pattern positions.

2. The method according to claim 1, **characterized in that** said step of monitoring (S30) a quality comprises:
- computing (S31) at least one quality measure, based on amplitudes of said associated acoustic signals (15);
- assigning (S33), if said quality measure is below a predetermined threshold, the pattern to be free from acoustically generated errors; and
- alerting (S35), if said quality measure exceeds said predetermined threshold, an operator with a warning for possible interaction errors.

3. The method according to claim 2, **characterized in that** said step of monitoring (S30) a quality further comprises:
- defining (S34) a map of areas of said target (7) in which said quality measure exceeds said predetermined threshold, whereby said warning comprises said map.

4. The method according to claim 2 or 3, **characterized in that** said step of computing (S31) at least one quality measure comprises calculating at least one of a first average measure and first variation measure of amplitudes along a first direction in said two-dimensional pattern, wherein said quality measure is based on said at least one of said first average measure and said first variation measure.

5. The method according to 4, **characterized in that** said step of computing (S31) at least one quality measure comprises calculating at least one of a second average measure and second variation measure of amplitudes along a second direction in said two-dimensional pattern, said second direction being transverse to said first direction, wherein said quality measure is further based on said at least one of said second average measure and said second variation measure.

6. The method according to any one of the claims 2 to 5, **characterized in that** said step of computing (S31) at least one quality measure comprises searching for systematic appearances, with respect to said associated positions at said two-dimensional pattern, of enhanced amplitudes in said recorded acoustic signals, wherein said possible interaction errors comprises mura.

7. The method according to any one of the claims 1 to 6, **characterized in that** said step of monitoring (S30) a quality comprises:
- identifying prominent frequencies in said recorded acoustic signals (15); and
- correlating periods of appearance of said prominent frequencies to operation sequences of said pattern interaction.

8. The method according to any one of the claims 1 to 7, **characterized by** comprising the further step of:
- storing said recorded acoustic signals (15) and their associated pattern positions from different interaction sessions in a history database;
- searching said history database for trends in acoustic signal (15) changes with time; and
- proposing possible of needs of maintenance based on said trends.

9. The method according to any one of the claims 1 to 8, **characterized in that** said microlithography device (50) is a pattern generator, wherein said step of interacting (S10) with a two-dimensional pattern comprises generating a two-dimensional pattern on a target (7) by exposing said target (7) for electromagnetic radiation according to predefined pattern print data.

10. The method according to any one of the claims 1 to 8, **characterized in that** said microlithography device (50) is a pattern measuring device, wherein said step of interacting (S10) with a two-dimensional pattern comprises generating a two-dimensional image of a pattern on a target (7) by exposing said target (7) for electromagnetic radiation.

11. The method according to any one of the claims 1 to 8, **characterized in that** said microlithography device (50) is a pattern inspection device, wherein said step of interacting (S10) with a two-dimensional pattern comprises generating deviance data of a pattern on a target (7) in relation to predefined pattern print data by exposing said target (7) for electromagnetic radiation.

12. A microlithography device (50), comprising:
- optical components (62, 64) defining an optical path (11);
- interaction control means (80) configured for controlling a relative movement of said optical path (11) in two dimensions relative to a target (7), thereby enabling exposure of a two-dimensional pattern for electromagnetic radiation;
- at least one acoustic sensor (84) arranged in vicinity of said optical path (11); and
- a quality monitor (82) communicationally connected to or integrated with said interaction control means (80) and communicationally connected to said at least one acoustic sensor (84);
wherein said quality monitor (82) being configured for recording acoustic signals (15) during interaction operations and for associating said recorded acoustic signals (15) to positions of said two-dimensional pattern where interaction with said pattern was performed when respective said acoustic signals (15) were recorded;
wherein said quality monitor (82) being further configured for monitoring a quality of said interaction with said two-dimensional pattern based on said associated acoustic signals (15) and pattern positions.

13. The microlithography device according to claim 12, **characterized in that** the microlithography device (50) is a pattern generator, wherein said interaction control means (80) is a printing control means configured for controlling a relative movement of said optical path (11) in two dimensions relative to a target (7) and for modulating electromagnetic radiation reaching said target (7) through said optical path (11) according to predefined pattern print data, thereby enabling exposure of a two-dimensional pattern.

14. The microlithography device according to claim 12, **characterized in that** the microlithography device (50) is a pattern measuring device, wherein said interaction control means (80) is a measuring control means configured for generating a two-dimensional image of a pattern on a target (7) by exposing said target (7) for electromagnetic radiation.

15. The microlithography device according to claim 12, **characterized in that** the microlithography device (50) is a pattern inspection device, wherein said interaction control means (80) is an inspection control means configured for generating deviance data of a pattern on a target (7) in relation to predefined pattern print data by exposing said target (7) for electromagnetic radiation.
